# EUROPEAN PATENT SPECIFICATION

(11) **EP 3 087 622 B1**
(45) Date of publication and mention of the grant of the patent: **30.09.2020**
(21) Application number: 14790994.9
(22) Date of filing: 21.10.2014
(51) Int. Cl.: H01L 51/52

(54) **LIGHT EXTRACTING ELECTRODE AND ORGANIC LIGHT EMITTING DIODE WITH LIGHT EXTRACTING ELECTRODE**
LICHTEXTRAKTIONSELEKTRODE UND ORGANISCHE LICHTEMITTIERENDE DIODE MIT EINER LICHTEXTRAKTIONSELEKTRODE
ÉLECTRODE D'EXTRACTION DE LUMIÈRE ET DIODE ÉLECTROLUMINESCENTE ORGANIQUE PRÉSENTANT UNE ÉLECTRODE D'EXTRACTION DE LUMIÈRE

(30) Priority: 26.12.2013 US 201361920792 P
(43) Date of publication of application: 02.11.2016
(73) Proprietor: Vitro Flat Glass LLC, Cheswick, PA 15024 (US)
(72) Inventor: BHANDARI, Abhinav, Cranberry, Pennsylvania 16066 (US); BUHAY, Harry, Allison Park, Pennsylvania 15101 (US)
(74) Representative: f & e patent
(86) International application number: PCT/US2014/061568
(87) International publication number: WO 2015/099871

(56) References cited:
- WO-A1-2013/001891
- WO-A1-2013/083712
- WO-A2-2007/127870
- WO-A2-2013/056155
- JP-A- H08 222 374
- US-A1- 2003 062 520
- US-A1- 2006 250 084
- US-A1- 2008 012 471
- US-A1- 2009 233 037
- US-A1- 2013 248 846
- MINGLI YAN ET AL: "Silver nanocrystals with special shapes: controlled synthesis and their surface-enhanced Raman scattering properties", RSC ADVANCES, vol. 4, no. 1, 5 November 2013 (2013-11-05), page 98, XP055169388, ISSN: 2046-2069, DOI: 10.1039/c3ra44437f

## Description

### BACKGROUND OF THE INVENTION

### Field of the Invention

This invention relates generally to organic light emitting diodes (OLEDs) and, more particularly, to an organic light emitting diode having a conductive electrode with enhanced light emitting properties.

### Technical Considerations

An organic light emitting diode (OLED) is a device having an emissive layer that emits electromagnetic radiation, such as visible light, in response to the application of an electric current. The emissive layer is located between two electrodes (an anode and a cathode). When electric current is passed between the anode and the cathode (i.e., through the emissive layer), the emissive layer emits electromagnetic energy. OLEDs are used in numerous applications, such as television screens, computer monitors, mobile phones, personal digital assistants (PDAs), watches, lighting, and various other electronic devices.

OLEDs provide numerous advantages over conventional inorganic devices, such as liquid crystals used for displays and incandescent or compact fluorescent lamps (CLFs) and other lighting applications. For example, an OLED functions without the need for a back light. In low ambient light, such as a dark room, an OLED screen can achieve a higher contrast ratio than conventional liquid crystal displays. OLEDs are also thinner, lighter, and more flexible than liquid crystal displays. OLEDs require less energy to operate and can provide cost savings compared to incandescent or compact fluorescent lamps.

However, one disadvantage with OLED devices is that a significant amount of the electromagnetic energy generated by the emissive layer is not emitted from the OLED device. A large portion of the generated electromagnetic energy is trapped within the OLED device due to the "optical waveguide effect" caused by the reflection of electromagnetic radiation at the interfaces of the various layers of the OLED device. In a typical OLED lighting device, about 80% of the visible light emitted from the emissive layer is trapped inside the OLED device due to this optical waveguide effect. Thus, only about 20% of the light generated by the emissive layer is actually emitted by the OLED device.

It would be advantageous to provide an OLED device in which more electromagnetic radiation produced by the emissive layer is emitted from the OLED device, compared to conventional OLED devices. For example, it would be advantageous to provide a way to reduce the optical waveguide effect in at least one layer of the OLED device to increase the OLED emission. It would also be advantageous to provide a method of making an OLED device having a reduced optical waveguide effect to promote increased electromagnetic emission from the OLED device.

WO 2013/056155 A2 relates to OLED and PV devices including transparent electrodes that are formed of conductive nanostructures and methods of improving light out-coupling in OLED and input-coupling in PV devices.

WO 2013/001891 A1 relates to a highly-reliable organic electroluminescence element which suppresses loss of light from surface plasmons generated on a metal surface, which increases the efficiency with which light is extracted to outside of the element; and which is not prone to short circuits within the element. This organic electroluminescence element is provided with a metal layer having in the surface nanosize concavities/convexities formed by a nanoparticle structure in which nanoparticles are planarly arranged; and an organic layer disposed on the concave/convex surface of the metal layer and configured from multiple layers including a light-emitting layer. The interfaces between the layers in the organic layer have flatter surfaces than the concave/convex surface of the metal layer.

US 2008/0012471 A1 describes an organic light-emitting diode (OLED) device, comprising: a transparent substrate, a transparent thin-film transistor located over the substrate; a light-emitting element formed over the transparent thin-film transistor, wherein the light-emitting element comprises a first transparent extensive electrode formed at least partially over a portion of the transparent thin-film transistor, a layer of light-emitting organic material, and a second reflective electrode formed over the layer of light-emitting organic material; a low-index layer formed between the first transparent extensive electrode and the thin-film transistor; and a light-scattering layer formed between the low-index layer and the second reflective electrode, or formed as part of the second reflective electrode.

US 2006/0250084 A1 describes an OLED device comprising: a) a substrate, b) an OLED formed over the substrate comprising a first electrode, a partially transparent second electrode through which light from the OLED is emitted, and at least one layer of organic light-emitting material disposed between the first electrode and partially transparent second electrode; and c) an encapsulation layer deposited over the partially transparent second electrode, wherein the encapsulating layer comprises one or more component layers, and wherein the encapsulating layer and the partially transparent second electrode combined have a transparency greater than the transparency of the partially transparent second electrode in the absence of the encapsulating layer, or wherein the encapsulating layer and the partially transparent second electrode combined have an absorbance less than the absorbance of the partially transparent second electrode in the absence of the encapsulating layer. To provide adequate encapsulation, in accordance with various embodiments of the invention at least one component layer of the encapsulating layer is deposited by atomic layer deposition, or the total thickness of encapsulating layer is at least about 150 nm. In a preferred embodiment, both such features are incorporated.

WO 2013/083712 A1 relates to an organic OLED device in a layered structure comprising a substrate, a bottom electrode, wherein the bottom electrode is closer to the substrate than the top electrode, an electrically active region, the electrically active region comprising one or more organic layers and being provided between and in electrical contact with the bottom electrode and the top electrode, a light emitting region provided in the electrically active region, and a roughening layer, the roughening layer being provided as non-closed layer in the electrically active region and providing an electrode roughness to the top electrode by roughening the top electrode on at least one of an inner side facing the electrically active region and an outer side of the top electrode facing away from the electrically active region. Furthermore, a further organic light emitting device, and a method of producing an organic light emitting device are provided.

WO 2007/127870 A2 relates to a cathode that contains nanostructures that extend into the organic layer of an OLED. The cathode can have an array of nanotubes or a layer of nanoclusters extending out from its surface. In another arrangement, the cathode is patterned and etched to form protruding nanostructures using a standard lithographic process. Various methods for fabricating these structures are provided, all of which are compatible with large-scale manufacturing. OLEDs made with these novel electrodes have greatly enhanced electron injection, have good environmental stability.

US 2003/062520 A1 describes a light emitting device and a manufacturing method thereof and a display used the light emitting device, in which fine patterning for the light emitting device is realized by a simple process and the light leakage is prevented and the efficiency at extracting light is increased. The light emitting device provides an organic electroluminescent device in which electrodes and a luminescent layer are formed, a diffraction grating or a zone plate, and a filter. Light emitted from the luminescent layer transmits through the diffraction grating or the zone plate, which is formed with a designated grating pitch, or is reflected at the diffraction grating or the zone plate. With this, the transmitting or reflecting light is controlled to be in a designated angle region. And when the light is transmitted through the filter, light having different color tone and chromaticity from those of the light emitted from the luminescent layer is extracted.

JP H08 222374 A relates to an element in which the anode is a transparent or semitransparent electrode and the cathode is a metallic electrode. The transparent or semitransparent anode, a positive hole injection layer, an organic emitter layer, a light absorbing/diffusing layer, and the cathode formed by the metallic electrode are stacked on a transparent substrate in that order. In an organic electroluminescent element of another constitution, an organic emitter layer is sandwiched between a pair of electrodes as an essential component layer, with either of the electrodes being transparent or semitransparent and the other having light absorption and diffusion properties. To give the electrodes light absorption and diffusion properties, in the case of a cathode a mixture of a material having light absorption and diffusion properties and a metal with a work function of 4.0 eV or less may be used to fabricate the electrode.

The article "Silver nanocrystals with special shapes: controlled synthesis and their surface-enhanced Raman scattering properties", Mingli Yan et al., RSC Advances, 2014, vol. 4, no.1, p.98-104 relates to the controlled synthesis of silver nanoparticles having certain shapes in aqueous hydrogen fluoride solution at room temperature.

US 2009/0233037 A1 relates to a reflective article, such as a solar mirror, including a highly transparent substrate having a first major surface and a second major surface. At least one reflective coating is formed over at least a portion of one of the surfaces, e.g., the second major surface (or alternatively, the first major surface). The reflective coating includes at least one metallic layer. An encapsulation structure can be formed over at least a portion of the second reflective coating.

US2013/248846 A1 relates to electrically conductive multilayers that combine a low resistivity with a high luminous transmission and a low roughness, such as: Si₃N₄/SnZnOₓ/ZnO/Ag/Ti/ITO or Si₃N₄/ SnZnOₓ/ZnO/Ag/Ti/ZnO/SnZnOₓ/ZnO/Ag/Ti/ITO.

### SUMMARY OF THE INVENTION

The present invention is as defined in the appended independent claims. Preferred variants are included in the appended dependent claims.

### BRIEF DESCRIPTION OF THE DRAWINGS

Fig. 1 is a side, sectional view illustrating an OLED device incorporating a light scattering electrode;
Fig. 2 is a side, sectional view of the OLED device of Fig. 1 incorporating additional layers;
Fig. 3 is a micrograph of Sample 1c (of Example 1) after heating;
Fig. 4 is a three-dimensional atomic force micrograph (50 microns by 50 microns) for the Sample 1 c of Fig. 3;
Fig. 5 is a micrograph of the Sample 1c of Fig. 3 after three months;
Fig. 6 is a two-dimensional atomic force micrograph (50 microns by 50 microns) of the Sample 1c of Fig. 5;
Fig. 7 is a micrograph of Sample 7c (from Example 2) after heating;
Fig. 8 is a two-dimensional atomic force micrograph (50 microns by 50 microns) of the Sample 7c of Fig. 7; and
Fig. 9 is a three-dimensional atomic force micrograph (50 microns by 50 microns) for the Sample 7c of Fig. 7.

### DESCRIPTION OF THE PREFERRED ASPECTS

As used herein, spatial or directional terms, such as "left", "right", "inner", "outer", "above", "below", and the like, relate to the invention as it is shown in the drawing figures. All ranges disclosed herein are to be understood to encompass the beginning and ending range values and any and all subranges subsumed therein.

The term "film" refers to a region of a coating having a desired or selected composition. A "layer" comprises one or more "films". A "coating" or "stack" comprises one or more "layers". The term "organic material" includes polymers as well as small molecule organic materials, such as those used to fabricate organic opto-electronic devices. The term "over" means "on or above". The terms "polymer" or "polymeric" include oligomers, homopolymers, copolymers, and terpolymers. The term "visible light" means electromagnetic energy having a wavelength in the range of 380 nm to 780 nm. The term "infrared radiation" means electromagnetic energy having a wavelength in the range of greater than 780 nm to 100,000 nm. The term "ultraviolet radiation" means electromagnetic energy having a wavelength in the range of 100 nm to less than 380 nm.

For purposes of the following discussion, the invention will be discussed with reference to a bottom-emitting OLED device. However, it is to be understood that the invention is not restricted to use with bottom-emitting OLED devices but could be practiced with top-emitting OLED devices and also with devices in other fields, for example, solar cells, such as photovoltaic thin film solar cells.

The invention comprises, consists of, or consists essentially of, the following aspects of the invention, in any combination. Various aspects of the invention are illustrated in separate drawing figures herein. However, it is to be understood that this is simply for ease of illustration and discussion. In the practice of the invention, one or more aspects of the invention shown in one drawing figure can be combined with one or more aspects of the invention shown in one or more of the other drawing figures.

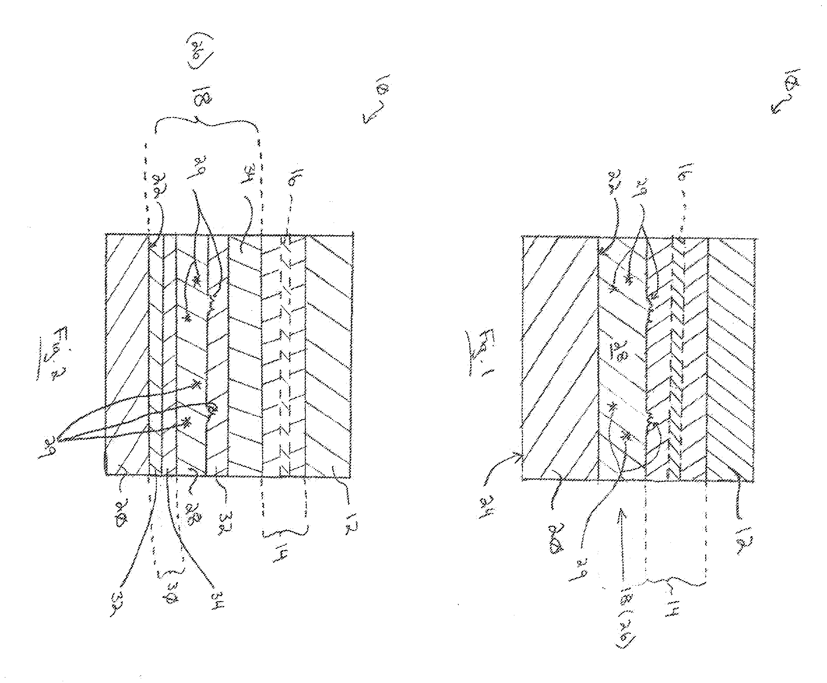

A basic OLED device (OLED) 10 is shown in Fig. 1. The OLED device 10 includes a first electrode (e.g., top electrode) 12, an active stack 14 incorporating an electroluminescent emissive layer 16, a second electrode (e.g., bottom electrode) 18, and a substrate 20. The substrate 20 has a first surface 22 (e.g., top surface) and a second surface 24 (e.g., bottom surface). The emissive layer 16 can include an electroluminescent emissive organic material.

For purposes of the following discussion, the OLED 10 will be described as a bottom-emitting OLED. The first electrode 12 will be considered the "cathode" and the second electrode 18 will be considered the "anode". However, this is simply for ease of describing the invention and should not be considered as limiting. The positions of the electrodes could be reversed, such as for a top-emitting OLED. The general structure and operation of a conventional OLED device will be well understood by one of ordinary skill in the art and, therefore, will not be described in detail.

In the practice of the invention and as described below, at least one of the first and second electrodes 12, 18 is a light extracting electrode 26 of the invention. The light extracting electrode 26 is a multilayer structure incorporating at least one metallic layer 28 incorporating one or more light extracting features 29, described in more detail below, and further layers, as described in more detail below.

In the following discussion, the light extracting electrode 26 will be described with respect to the second electrode 18 (for example, the anode). For ease of discussion, the light extracting electrode 26 (e.g., anode) will be referred to herein as an "electrode" (or "anode") regardless of the multilayer structure that includes the metallic layer 28 as well as additional layers that are present for functions other than electron transport. Both of the first and second electrodes 12, 18 of the OLED can be transparent or one electrode can be transparent and the other electrode can be opaque (for example, reflective). For bottom emitting OLEDs, the second electrode 18 (closest to the substrate 20) is preferably transparent to the generated electromagnetic radiation.

As used herein, by "transparent" is meant having a transmittance of electromagnetic radiation at one or more desired wavelengths (for example, a visible light transmittance at a wavelength of 550 nanometers (nm)) of at least 50%, such as at least 60%, such as at least 70%, such as at least 80%, such as at least 90%, such as at least 95%. As used herein, by "opaque" is meant having a transmittance of electromagnetic radiation at one or more desired wavelengths (such as visible light at a wavelength of 550 nm) of less than 50%, such as less than 40%, such as less than 30%, such as less than 20%, such as less than 10%, such as less than 5%, such as 0%. As used herein, by "reflective" is meant that at least a portion of the electromagnetic energy generated by the active stack 14 is reflected by the electrode.

Examples of suitable materials for the cathode (e.g., the first electrode 12 in the illustrated example) include metals, such as barium, calcium, and magnesium. The cathode typically has a low work function. For OLEDs in which the light emission is only or is primarily out of the bottom of the device 10 (through the substrate side of the device 10), the first electrode 12 can be opaque and/or reflective. For example, the first electrode 12 can be reflective or at least partly reflective of at least a portion of the light generated by the active stack 14. The first electrode 12 can reflect at least 20%, such as at least 30%, such as at least 40%, such as at least 50%, such as at least 60%, such as at least 70%, such as at least 80%, such as at least 90%, of electromagnetic energy having a wavelength of 550 nm. The first electrode 12 can be a relatively thick reflective metal layer having high electrical conductivity. Alternatively, if it is desired that light be emitted out of the top of the device 10, the first electrode 12 can be transparent.

The active layer 14 can include any conventional emissive layer 16. Examples of materials suitable for the emissive layer 16 include small molecules, such as organometallic chelates (e.g., Alq₃), fluorescent and phosphorescent dyes, and conjugated dendrimers. Further examples of suitable materials include triphenylamine, perylene, rubrene, and quinacridone. Alternatively, electroluminescent polymeric materials can be used. Examples of conductive polymers include poly(p-phenylene vinylene) and polyfluorene. Phosphorescent materials could also be used. Examples of such materials include polymers, such as poly(n-vinylcarbazole), in which an organometallic complex, such as an iridium complex, is added as a dopant.

For bottom emitting OLEDs, the substrate 20 is preferably transparent. Examples of suitable materials for the substrate 20 include glass, such as conventional soda-lime silicate glass, for example, float glass. For applications such as lighting, the substrate 20 preferably has a high visible light transmission at a reference wavelength of 550 nanometers (nm) and a reference thickness of 3.2 mm. By "high visible light transmission" it is meant visible light transmission (at a reference wavelength of 550 nm and a reference thickness of 3.2 mm) of at least 85%, such as at least 87%, such as at least 90%, such as at least 91%, such as at least 92%, such as at least 93%, such as at least 95%.

Examples of glass that can be used for the invention include Starphire®, Solarphire®, Solarphire® PV, and CLEAR™ glass, all commercially available from PPG Industries, Inc. of Pittsburgh, Pennsylvania.

The substrate 20 can have any desired thickness, such as in the range of 0.5 mm to 10 mm, such as 1 mm to 10 mm, such as 1 mm to 4 mm, such as 2 mm to 3.2 mm.

As shown in Fig. 1, the light extracting electrode 26 comprises a metallic layer 28 having light scattering features 29 that increase the haze (i.e., light scattering) of the light extracting electrode 26.

Examples of materials suitable for the metallic layer 28 include metallic platinum, iridium, osmium, palladium, aluminum, gold, copper, silver, and/or mixtures and/or alloys thereof. In a preferred aspect, the metallic layer 28 is or includes metallic silver.

The light scattering features 29 are located in the metallic layer 28 and/or on a surface of the metallic layer 28. The light scattering features 29 are part of the metallic layer 28 or are incorporated into the metallic layer 28. The light scattering features 29 are not part of a separate coating or layer deposited on the metallic layer 28.

Examples of the light scattering features 29 include defects and/or dendrites. By "dendrite" or "dendrite-shaped" is meant a branching, treelike feature in or on the metallic layer 28. For example, the dendrite can be a crystal or crystalline mass. By "defect" is meant a spot and/or region and/or area in and/or on the metallic layer 28 that scatters electromagnetic radiation. Examples of defects include projections extending from a surface of the metallic layer, cracks or voids formed in and/or on the metallic layer 28, areas of different density in and/or on the metallic layer 28, and areas of different chemical composition in and/or on the metallic layer 28. The presence of the light scattering features 29 scatters electromagnetic energy and helps reduce the waveguide effect described above.

For example, the dendrites can have a diameter in the range of 10 microns to 50 microns, such as 10 microns to 40 microns, such as 20 microns to 40 microns, such as 30 microns to 40 microns. For example, the dendrites can have an average diameter in the range of 30 microns to 35 microns.

For example, the dendrites and/or defects can comprise projections extending upwardly from a surface, e.g., the upper surface 22, of the metallic layer 28. For example, at least some of the projections can have a height (with respect to the surface of the metallic layer 28) in the range of 10 nm to 80 nm, such as 20 nm to 60 nm, such as 30 nm to 60 nm, such as 30 nm to 50 nm. For example, at least some of the projections can have a height in the range of 30 nm to 50 nm.

For example, at least some of the projections can have a minimum height of 5 nm, such as 10 nm, such as 15 nm, such as 20 nm, such as 25 nm, such as 30 nm, such as 35 nm, such as 40 nm, such as 50 nm.

For example, at least some of the projections can have a maximum height of 100 nm, such as 90 nm, such as 80 nm, such as 70 nm, such as 60 nm, such as 55 nm, such as 50 nm, such as 45 nm, such as 40 nm.

Fig. 2 illustrates additional layers, incorporated into the light extracting electrode 26. These additional layers will be described as part of the "electrode" even though one or more of the layers may be present for functions other than electron transport.

The light extracting electrode 26 according to the present invention incorporates an underlayer 30 positioned between the metallic layer 28 and the top surface 22 of the substrate 20.

The underlayer 30 includes a plurality of layers or films.

The underlayer 30 can have a minimum thickness of 10 nm, such as 15 nm, such as 20 nm, such as 25 nm, such as 30 nm, such as 35 nm, such as 40 nm, such as 45 nm, such as 50 nm, such as 55 nm, such as 60 nm, such as 65 nm, such as 70 nm, such as 80 nm, such as 90 nm, such as 100 nm, such as 110 nm, such as 115 nm.

The underlayer 30 can have a maximum thickness of 120 nm, such as 115 nm, such as 110 nm, such as 105 nm, such as 100 nm, such as 95 nm, such as 90 nm, such as 85 nm, such as 80 nm, such as 75 nm, such as 70 nm, such as 65 nm, such as 60 nm, such as 55 nm, such as 50 nm, such as 45 nm, such as 40 nm, such as 30 nm, such as 25 nm, such as 20 nm.

In a preferred aspect, the underlayer 30 has a thickness in the range of 10 nm to 120 nm, such as 30 nm to 80 nm, preferably 30 nm to 80 nm, more preferably 30 nm to 70 nm.

The underlayer 30 includes a zinc oxide layer over a zinc stannate layer.

The zinc oxide layer can be deposited from a zinc target that includes one or more other materials to improve the sputtering characteristics of the target, such as to increase the conductivity of the zinc target. For example, the zinc target can include a small amount (e.g., up to 10 wt.%, such as up to 5 wt.%) of a material to improve sputtering. In which case, the resultant zinc oxide layer would include a small percentage of an oxide of the added material, e.g., up to 10 wt.% of the material oxide, e.g., up to 5 wt.% of the material oxide. A layer deposited from a zinc target having up to 10 wt.% of an additional material to enhance the sputtering characteristics of the zinc target is referred to herein as "a zinc oxide layer" even though a small amount of the added material (e.g., material oxide) may be present.

Examples of materials that can be added to the zinc target to improve sputtering include conductive metals. For example, the added material can be selected from Fe, Mn, Al, Ce, Sn, Sb, Hf, Zr, Ni, Bi, Ti, Co, Cr, Si, and combinations thereof.

In a preferred aspect, the added material is tin. The small amount of tin in the zinc target (e.g., less than or equal to 10 wt.%, such as less than or equal to 5 wt.%) is believed to form tin oxide in the predominantly zinc oxide layer. As discussed above, such a layer will be referred to as a "zinc oxide" layer.

The underlayer 30 includes also a zinc stannate layer. By "zinc stannate" is meant a composition of the formula: Zn_{X}Sn_{1-X}O_{2-X} (Formula 1) where "x" varies in the range of greater than 0 to less than 1. For instance, "x" can be greater than 0 and can be any fraction or decimal between greater than 0 to less than 1. A zinc stannate layer has one or more of the forms of Formula 1 in a predominant amount.

In a preferred aspect of the invention, x = 2/3. A zinc stannate layer in which x=2/3 is conventionally referred to as "Zn₂SnO₄".

The underlayer 30 is a multilayer structure having a first layer 32 deposited over at least a portion of the top surface 22 of the substrate 12 and a second layer 34 deposited over the first layer 32. The first layer 32 is zinc stannate. In a preferred aspect, the zinc stannate is Zn₂SnO₄.

The second layer 34 is zinc oxide (with or without the tin oxide as described above). In the present invention, the first layer 32 is a zinc stannate layer and the second layer 34 is a zinc oxide layer. In a more preferred aspect, the first layer 32 is Zn₂SnO₄ and the second layer 34 is zinc oxide (with up to 10 wt.% tin oxide, such as up to 5 wt.% tin oxide).

The first layer 32 can have a minimum thickness of 5 nm, such as 10 nm, such as 15 nm, such as 20 nm, such as 25 nm, such as 30 nm, such as 35 nm, such as 40 nm, such as 45 nm, such as 50 nm, such as 55 nm.

The first layer 32 can have a maximum thickness of 60 nm, such as 55 nm, such as 50 nm, such as 45 nm, such as 40 nm, such as 35 nm, such as 30 nm, such as 25 nm, such as 20 nm, such as 15 nm, such as 10 nm.

In a preferred aspect, the first layer 32 has a thickness in the range of 5 nm to 60, such as 5 nm to 50 nm, such as 7.5 nm to 35 nm, such as 10 nm to 25 nm, such as 15 nm to 25 nm, such as 19.5 nm to 25 nm, such as 20 nm to 25 nm, such as 20 nm to 22 nm.

The second layer 34 can have a minimum thickness of 5 nm, such as 8 nm, such as 10 nm, such as 12 nm, such as 14 nm, such as 16 nm, such as 18 nm.

The second layer 34 can have a maximum thickness of 20 nm, such as 18 nm, such as 16 nm, such as 14 nm, such as 12 nm, such as 10 nm, such as 8 nm, such as 6 nm.

In a preferred aspect, the second layer 34 has a thickness in the range of 5 nm to 20 nm, such as 7.5 nm to 20 nm, such as 10 nm to 15 nm, such as 10 nm to 11 nm.

An optional primer layer 36 can be provided over the metallic layer 28. The primer layer 38 can be a single film or a multiple film layer. The primer layer 38 can include an oxygen-capturing material that can be sacrificial during the deposition process to control degradation or oxidation of the metallic layer 28 during the sputtering process or during subsequent heating processes. Examples of materials useful for the primer layer 38 include titanium, silicon, silicon dioxide, silicon nitride, silicon oxynitride, nickel-chrome alloys (such as Inconel), zirconium, aluminum, alloys of silicon and aluminum, alloys containing cobalt and chromium (e.g., Stellite®), and mixtures thereof.

For example, the primer layer 36 can be or can include titanium.

The primer layer 36 can have a thickness in the range of 0.5 nm to 5 nm, e.g., 0.5 nm to 3 nm, e.g., 0.5 nm to 1 nm, e.g., 0.5 nm to 0.6 nm.

An optional top layer 38 can be provided over the primer layer 36 (if present) or over the metallic layer 28 (if the primer layer 36 is not present). The top layer 38 can be a protective layer to provide mechanical or chemical durability to the underlying layers.

The top layer 38 can include one or more metal oxides, silicon oxides, aluminum oxides, aluminosilicates, silicon nitrides, silicon carbides, and silicon oxycarbides. Examples of materials suitable for the top layer 38 include oxides of one or more of zirconium, zinc, tin, aluminum, silicon, and mixtures and/or alloys thereof. For example, the top layer 38 can include zinc and tin. For example, the top layer 38 can be a mixture of zinc oxide and tin oxide and/or an alloy of zinc and tin, such as zinc stannate.

For example, the top layer 38 can be a single coating layer comprising 0 wt.% to 100 wt.% alumina and/or 0 wt.% to 100 wt.% silica and/or 0 wt.% to 100 wt.% zirconium oxide. For example, the top layer 38 can include silica and alumina having, for example, 1 wt.% to 99 wt.% silica and 99 wt.% to 1 wt.% alumina, such as at least 40 wt.% silica and 60 wt.% or less alumina, such as at least 70 wt.% silica and 30 wt.% or less alumina, such as at least 75 wt.% silica, such as at least 80 wt.% silica, such as at least 85 wt.% silica. In one non-limiting aspect, the top layer 38 comprises 85 wt.% silica and 15 wt.% alumina. In another non-limiting aspect, the top layer 38 comprises 40 wt.% silica and 60 wt.% alumina. In a further non-limiting aspect, the top layer 38 includes a mixture of silica and alumina.

The top layer 38 can have a minimum thickness of 0.5 nm, such as 0.6 nm, such as 1 nm, such as 2 nm, such as 5 nm, such as 10 nm, such as 20 nm, such as 30 nm, such as 40 nm, such as 50 nm, such as 60 nm, such as 70 nm, such as 75 nm, such as 100 nm, such as 110 nm, such as 120 nm, such as 150 nm, such as 200 nm, such as 250 nm, such as 300 nm, such as 500 nm, such as 700 nm, such as 1,000 nm, such as 2,000 nm, such as 3,000 nm.

The top layer 38 can have a maximum thickness of 5,000 nm, such as 3,000 nm, such as 2,000 nm, such as 1,000 nm, such as 500 nm, such as 300 nm, such as 200 nm, such as 150 nm, such as 100 nm, such as 90 nm, such as 80 nm.

In a preferred aspect, the top layer 38 has a thickness in the range of 0.5 nm to 5,000 nm, such as 0.5 nm to 3,000 nm, such as 0.5 nm to 2,000 nm, such as 0.5 nm to 1,000 nm, such as 1 nm to 500 nm, such as 2 nm to 300 nm, such as 5 nm to 300 nm, e.g., 50 nm to 200 nm, such as 50 nm to 150 nm, such as 50 nm to 120 nm, such as 60 nm to 120 nm, such as 70 nm to 120 nm, such as 70 nm to 100 nm, such as 70 nm to 80 nm.

In an alternative aspect of the invention, the top layer 38 comprises a silica/alumina mixture having at least 40 wt.% silica, such as at least 50 wt.% silica, such as at least 60 wt.% silica, such as at least 70 wt.% silica, such as at least 80 wt.% silica, such as in the range of 80 wt.% to 90 wt.% silica and 10 wt.% to 20 wt.% alumina, e.g., 85 wt.% silica and 15 wt.% alumina. In this non-limiting aspect, the top layer 38 can have a thickness in the range of greater than 0 nm to 2 microns, such as 0.5 nm to 500 nm, such as 5 nm to 200 nm, such as 10 nm to 100 nm, such as 30 nm to 50 nm, such as 35 nm to 40 nm. In another non-limiting aspect, the top layer 38 can have a thickness in the range of greater than 0 nm to 1 micron, such as 0.5 nm to 10 nm, such as 10 nm to 25 nm, such as 10 nm to 15 nm.

The underlayer 30, metallic layer 28, optional primer 36, and optional top layer 38 can be deposited by any conventional method, such as, conventional chemical vapor deposition (CVD) and/or physical vapor deposition (PVD) methods. Examples of CVD processes include spray pyrolysis. Examples of PVD processes include electron beam evaporation and vacuum sputtering (such as magnetron sputter vapor deposition (MSVD)). Other coating methods could also be used, such as sol-gel deposition. The layers can be deposited by the same or differing methods.

In an optional aspect, the top layer 38 can be a conductive layer. Examples of suitable conductive materials include conductive oxides, such as conductive metal oxides.

Particular examples of conductive oxides include indium tin oxide (ITO), aluminum zinc oxide (AZO), or indium zinc oxide (IZO). The conductive properties of the top layer 34 may be beneficial in reducing the driving voltage for the OLED 10.

The light extracting electrode 26 (or metallic layer 28) can have a minimum sheet resistance of 1 ohm per square (Ω/□), such as 2 Ω/□, such as 4 Ω/□, such as 5 Ω/□, such as 5.5 Ω/□, such as 6 Ω/□, such as 6.5 Ω/□, such as 7 Ω/□, such as 8 Ω/□, such as 9 Ω/□, such as 10 Ω/□, such as 12 Ω/□, such as 13 Ω/□, such as 15 Ω/□, such as 17 Ω/□, such as 18 Ω/□, such as 20 Ω/□, such as 25 Ω/□, such as 30 Ω/□, such as 32 Ω/□, such as 34 Ω/□, such as 36 Ω/□, such as 40 Ω/□, such as 50 Ω/□, such as 55 Ω/□, such as 60 Ω/□.

The light extracting electrode 26 (or metallic layer 28) can have a maximum sheet resistance of 210 Ω/□, such as 200 Ω/□, such as 175 Ω/□, such as 150 Ω/□, such as 125 Ω/□, such as 100 Ω/□, such as 75 Ω/□, such as 50 Ω/□, such as 30 Ω/□, such as 20 Ω/□, such as 15 Ω/□, such as 13 Ω/□, such as 10 Ω/□, such as 8 Ω/□.

In a preferred aspect, the light extracting electrode 26 (or metallic layer 28) has a sheet resistance in the range of 1 Ω/□ to 20 Ω/□, such as 1 Ω/□ to 15 Ω/□, such as 1 Ω/□ to 10 Ω/□, such as 1 Ω/□ to 8 Ω/□, such as 2 Ω/□ to 8 Ω/□, such as 4 Ω/□ to 8 Ω/α.

The light extracting electrode 26 can have a minimum visible light transmittance (at a thickness of 2 mm) of 50 %, such as 60 %, such as 65 %, such as 70 %, such as 75 %, such as 78 %, such as 80 %, such as 83 %, such as 85 %, such as 90 %, such as 91 %, such as 92 %, such as 93 %, such as 95 %.

The light extracting electrode 26 can have a maximum visible light transmittance (at a thickness of 2 mm) of 99 %, such as 97 %, such as 96 %, such as 95 %, such as 93 %, such as 92 %, such as 91 %, such as 90 %, such as 85 %, such as 80 %, such as 70 %, such as 60 %.

In a preferred aspect, the light extracting electrode 26 has a visible light transmittance (at a thickness of 2 mm) in the range of 50 % to 97 %, such as 70 % to 95 %, such as 75 % to 95 %, such as 80 % to 95 %, such as 85 % to 95 %, such as 88 % to 95 %, such as 90 % to 95 %.

The light extracting electrode 26 can have a minimum haze of 0.04 %, such as 0.05 %, such as 0.07 %, such as 0.08 %, such as 0.1 %, such as 0.12 %, such as 0.15 %, such as 0.2 %, such as 0.3 %, such as 0.5 %, such as 0.8 %, such as 1 %, such as 1.5 %, such as 2 %, such as 3 %, such as 4 %, such as 5 %, such as 6 %, such as 7 %, such as 8 %, such as 9 %, such as 10 %, such as 12 %, such as 15 %.

The light extracting electrode 26 can have a maximum haze of 20 %, such as 15 %, such as 12 %, such as 10 %, such as 9 %, such as 8 %, such as 7 %, such as 6 %, such as 5 %, such as 4 %, such as 3 %, such as 2 %, such as 1 %.

In a preferred aspect, the light extracting electrode 26 has haze in the range of 0.5 % to 10 %, such as 1 % to 10 %, such as 1 % to 8 %.

The light extracting electrode 26 can have a minimum root mean square (RMS) surface roughness of 5 nm, such as 6 nm, such as 8 nm, such as 10 nm, such as 15 nm, such as 20 nm, such as 25 nm, such as 30 nm, such as 35 nm, such as 40 nm, such as 45 nm, such as 47 nm, such as 50 nm, such as 52 nm, such as 54 nm, such as 55 nm.

The light extracting electrode 26 can have a maximum root mean square surface roughness of 60 nm, such as 55 nm, such as 54 nm, such as 50 nm, such as 47 nm, such as 45 nm, such as 40 nm, such as 35 nm, such as 25 nm, such as 20 nm, such as 15 nm, such as 10 nm.

In a preferred aspect, the light extracting electrode 26 has a root mean square surface roughness in the range of 5 nm to 60 nm, such as 25 nm to 60 nm, such as 40 nm to 60 nm, such as 50 nm to 60 nm.

The light scattering features 29 of the metallic layer 28 can be provided by several methods.

For example, after the metallic layer 28 is formed on the substrate 20, the metallic layer 28 can be exposed to oxygen. For many metals, the metal reacts with oxygen to oxidize to form defects in or on the metal. For example, this exposure to oxygen can occur during the process to form the optional top layer 38 over the metallic layer 28 or as a separate step.

For example, the metallic layer 28 can be exposed to oxygen (such as to the ambient atmosphere) for a period of time in the range of I minute to 20 minutes, such as 1 minute to ten minutes, such as 1 minute to 5 minutes, such as 3 minutes to 5 minutes, such as 3 minutes to 4.5 minutes.

Another exemplary method to form light-scattering features 29 (e.g., haze-inducing defects) in the metallic layer 28 is by post heating. By "post-heating" is meant heating the substrate 12 and metallic layer 28 after deposition of the metallic layer 28. Post heating, either with or without exposure to oxygen, tends to oxidize the metal of the metallic layer 28 to form defects in or on the metallic layer and/or increase the haze of the metallic layer 28.

For example, the metallic layer 28 can be heated to a temperature in the range of 400 °C to 1000 °C, such as 500 °C to 900 °C, such as 600 °C to 800 °C, such as 700 °C to 800 °C, such as 700 °C to 750 °C.

The metallic layer 28 can be heated for a period of time in the range of I minute to 20 minutes, such as 1 minute to ten minutes, such as 1 minute to 5 minutes, such as 3 minutes to 5 minutes, such as 3 minutes to 4.5 minutes.

The heating can be conducted in a conventional oven or in a conveyor oven. For example, the conveyor oven can have a conveyor line speed in the range of 2.5 cm/min to 51 cm/min, such 5 cm/min to 38 cm/min, such as 5 cm/min to 28 cm/min, such as 5 cm/min to 20 cm/min, such as 10 cm/min to 20 cm/min.

The conveyor oven can have one or multiple heating chambers. For example, one or more of the heating chambers can have a temperature in the range of 400 °C to 1000 °C, such as 500 °C to 800 °C, such as 500 °C to 700 °C, such as 500 °C to 650 °C, such as 525 °C to 625 °C. The heating chambers can have the same or different temperatures.

Another exemplary method to induce the light-scattering features 29 is to expose the metallic layer 28 to a laser beam to form defects in the metallic layer 28. For example, this can be done prior to the application of the optional top layer 38. The defects can be cracks or voids formed in and/or on the metallic layer 28 by the laser. The defects can also be areas of different density caused by focusing the laser to a position on the surface or in the interior of the metallic layer 28.

A further exemplary way to induce these light-scattering features 29 is by exposing the metallic layer 28 to an oxygen plasma treatment. The oxygen plasma causes protrusions on the surface of the metallic layer 28.

A still further exemplary way of inducing light-scattering features 29 is by doping the metallic layer 28 with dopants that produce defects or otherwise increase the haze of the metallic layer 28. Examples of such dopants include copper, aluminum, and zinc. The dopant can react with or combine with or mix with the metal of the metallic layer 28 to form spots or areas having a different density and/or different composition than the rest of the metallic layer 28.

It is to be understood that all of the optional layers discussed above need not be present in the OLED 10. One or more of these optional layers can be provided as desired based on such considerations as cost, ease of manufacture, and desired end use of the OLED 10.

Operation of the OLED device 10 will now be described with particular reference to Fig. 1.

During operation, a voltage is applied across the first electrode 12 and the second electrode 18. A current of electrons flows from the cathode (e.g., first electrode 12) to the anode (e.g., second electrode 18) and, thus, through the emissive layer 16 (and the optional layers, if present). This electric current causes the emissive layer 16 to emit electromagnetic radiation (e.g., light) of a selected wavelength or range of wavelengths, depending upon the composition of the emissive layer 16. The light waves emitted by the emissive layer 16 travel into the metallic layer 28 of the second electrode 18. In a conventional OLED device, the majority of the electromagnetic radiation entering the second electrode 18 would be trapped by the waveguide effect. However, in the invention, at least a portion of this electromagnetic energy is scattered by the light scattering features 29. This scattering causes the light waves to travel more randomly and disrupts the waveguide effect, increasing the amount of electromagnetic energy that passes through the metallic layer 28, into the substrate 20, and then exits the bottom surface 24. The light scattering effect caused by the light scattering features 29 of the metallic layer 28 increases the overall light extraction for the OLED device 10.

The following Examples illustrate various aspects of the invention. However, it is to be understood that the invention is not limited to these specific aspects.

### EXAMPLES

In the following examples, the substrates were clear glass commercially available from PPG Industries Ohio, Inc. having a thickness of 2 millimeters (mm). The visible light transmittance (T) values and haze (Haze) values are percentage values and were measured using a Haze-Gard Plus hazemeter commercially available from BYK-Gardner USA. The coating layers were applied using a conventional Airco MSVD coater having a target width of 12.7 cm (5 inches) and a line speed of 152.4 cm (60 inches) per minute. "Zn90" means to a target having 90 wt.% zinc and 10 wt.% tin. "AI60" means a target having 60 wt.% aluminum and 40 wt.% silicon. "SnZn" means a target having 52.4 wt.% zinc and 47.6 wt.% tin (to deposit a Zn₂SnO₄ layer). All coater power settings are in kilowatts (Kw). All time values are in minutes. The sheet resistance values are in ohms per square (Ω/□). "O/R" means the value was out of measurement range. A "--" symbol means that the value was not measured. "M" means Mega Ohms. For the following Examples, replicates of substrates coated with particular coating layers are designated with a small letter after the coating number. For example, Samples 1a, 1b, 1c, 1d, etc. designate replicate glass substrates coated with coating 1. Physical characteristics, such as height of the projections, surface roughness, and diameter of the dendrites, were determined by conventional atomic force microscopy (AFM).

### Example 1 (not according to the present invention)

This Example illustrates a light scattering electrode structure having an underlayer of zinc oxide (with 10 wt.% tin oxide)/a metallic silver conductive layer/a top layer (protective layer) of 60 wt. % alumina and 40 wt.% silica.

Table 1 lists the coater power settings during deposition. Substrates were subjected to one pass under each target.

**TABLE 1**

| Coating # | Zn90 | Ag | Al60 | T | Haze |
|---|---|---|---|---|---|
| 1 | 5 | 2 | 50 | 64.7 | 0.23 |
| 2 | 5 | 1.5 | 50 | 72.5 | 0.16 |
| 3 | 5 | 1 | 50 | 76.7 | 0.09 |
| 4 | 5 | 0.5 | 50 | 79.9 | 0.1 |
| 5 | 5 | 0.25 | 50 | 87.7 | 0.08 |

The coated substrates were measured for sheet resistance before heating (Pre-Heat) and then heated in a box oven at 1300°F (704°C) for the times listed in Table 2. After heating, the coated substrates were allowed to cool to room temperature and then sheet resistance, transmittance, and haze were again measured (Post-Heat). The resultant values are shown in Table 2.

**TABLE 2**

| | | Sheet Resistance | | Post-Heat | |
|---|---|---|---|---|---|
| Sample | Time | Pre-Heat | Post-Heat | T | Haze |
| 1a | 3 | 15 | 6.5 | 73.4 | 4.69 |
| 1b | 3.5 | 13.5 | 5.5 | 70.2 | 7.41 |
| 1c | 4 | 14.4 | 5.7 | 68.9 | 8.71 |
| 1d | 4.5 | - | 7.1 | 69.5 | 8.27 |
| 1e | 5 | - | 6.2 | 66.7 | 9.2 |
| 2a | 3 | 23.2 | 13 | 78.9 | 4.88 |
| 2b | 3.5 | 23.6 | 13 | 77.6 | 6.7 |
| 2c | 4 | 24.7 | 17.7 | 77.4 | 7.58 |
| 3a | 3 | 65.5 | 223 | 79.9 | 2.46 |
| 3b | 3.5 | 61.4 | 202 | 78.6 | 3.21 |
| 3c | 4 | 61.7 | 206 | 75.5 | 3.62 |
| 4a | 3 | O/R | O/R | 85 | 0.42 |
| 4b | 3.5 | O/R | O/R | 87.1 | 0.44 |
| 4c | 4 | O/R | O/R | 91 | 0.2 |
| 5a | 3 | 0.6M | O/R | 92.6 | 0.07 |
| 5b | 3.5 | 10M | O/R | 92.8 | 0.23 |
| 6c | 4 | 14M | O/R | 92.5 | 0.6 |

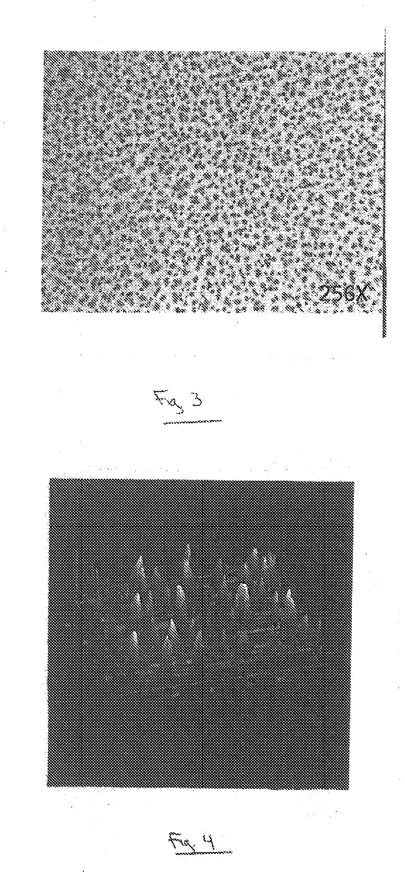

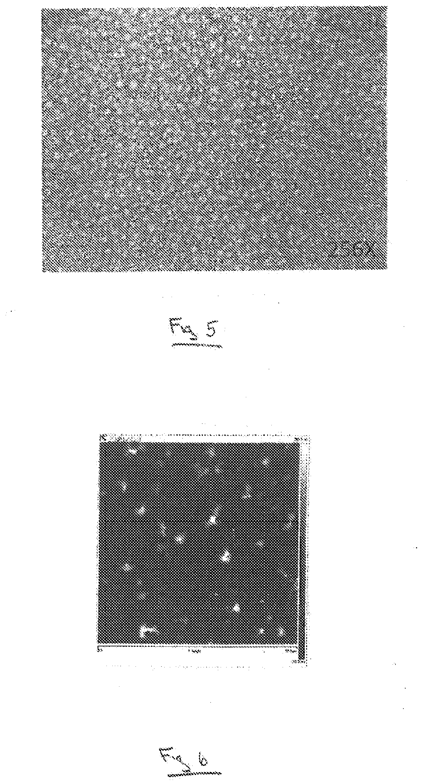

Fig. 3 is a micrograph of Sample 1c (Post-Heat) showing the defects in/on the metallic layer. Fig. 4 is a three-dimensional atomic force micrograph (50 microns by 50 microns) for the Sample 1c of Fig. 3. As can be seen, the metallic layer had defects (projections or spot defects) extending upwardly from the surface of the metallic layer. At least some of the defects had a height of 50 nm. For Sample 1c shown in Figs. 3 and 4, the Pre-Heat sample had a root mean square (RMS) surface roughness of 0.64 nm. Post-Heating, the sample had a RMS roughness of 3.97 between the defects and a RMS surface roughness of 47.6 nm including the defects. A replicate Sample 1c was measured after three months. Fig. 5 is a micrograph of the replicate Sample 1c after three months. Fig. 6 is a two-dimensional atomic force micrograph (50 microns by 50 microns) of the replicate Sample 1c of Fig. 5. The replicate Sample 1c had a Pre-Heat root mean square (RMS) surface roughness of 0.69 nm and a Post-Heat RMS surface roughness of 57.3 nm. After three months, the Sample 1c had a sheet resistance of 80 Ω/□.

### Example 2 (not according to the present invention)

This Example illustrates a light emitting electrode structure having an underlayer of zinc oxide (with 10 wt.% tin oxide)/a metallic silver layer/a top layer (conductive layer) of zinc doped indium oxide (IZO).

Table 3 lists the coater power settings during deposition of the listed targets. Substrates were coated with Zn90 and Ag for 1 pass and with IZO for 2 passes.

**TABLE 3**

| Coating # | Zn90 | Ag | IZ0 | T | Haze |
|---|---|---|---|---|---|
| 7 | 5 | 2 | 5 | 82.6 | 0.09 |
| 8 | 5 | 2.5 | 5 | 86.3 | 0.1 |
| 9 | 5 | 1 | 5 | 86.3 | 0.07 |
| 10 | 5 | 0.5 | 5 | 75.1 | 0.14 |
| 11 | 5 | 0.25 | 5 | 73.2 | 0.14 |

The coated substrates were measured for sheet resistance before heating (Pre-Heat) and then heated in a box oven at 1300°F (704°C) for the times listed in Table 4. After heating, the coated substrates were allowed to cool to room temperature and then sheet resistance, transmittance, and haze were again measured (Post-Heat). The resultant values are shown in Table 4.

**TABLE 4**

| | Sheet Resistance | | | Post-Heat | |
|---|---|---|---|---|---|
| Sample | Time | Pre-Heat | Post-Heat | T | Haze |
| 7a | 3 | 4.2 | 5.6 | 83.3 | 1.47 |
| 7b | 3.5 | 4.4 | 8.4 | 83.1 | 2.07 |
| 7c | 4 | 4 | 8.4 | 82.3 | 2.41 |
| 7d | 4.5 | - | 11.8 | 80 | 2.96 |
| 8a | 3 | 5.7 | 8.6 | 85 | 0.98 |
| 8b | 3.5 | 5.7 | 10-12 | 84.5 | 1.3 |
| 8c | 4 | 5.7 | 18-20 | 83.2 | 2.12 |
| 9a | 3 | 9.3 | 32-36 | 82.9 | 0.87 |
| 9b | 3.5 | 9.6 | 52-56 | 82.2 | 1.13 |
| 9c | 4 | 10 | 170-220 | 78 | 2.23 |
| 10a | 3 | 43 | 0.5M | 78.1 | 0.62 |
| 10b | 3.5 | 40.5 | 0.2M | 78.6 | 0.25 |
| 10c | 4 | 36 | 0.5M | 78.3 | 0.38 |
| 11a | 3 | 119 | 0.7M | 77.4 | 0.37 |
| 11b | 3.5 | 116.5 | 0.73M | 79.3 | 1.15 |
| 11c | 4 | 112 | 0.76M | 78.9 | 2.61 |

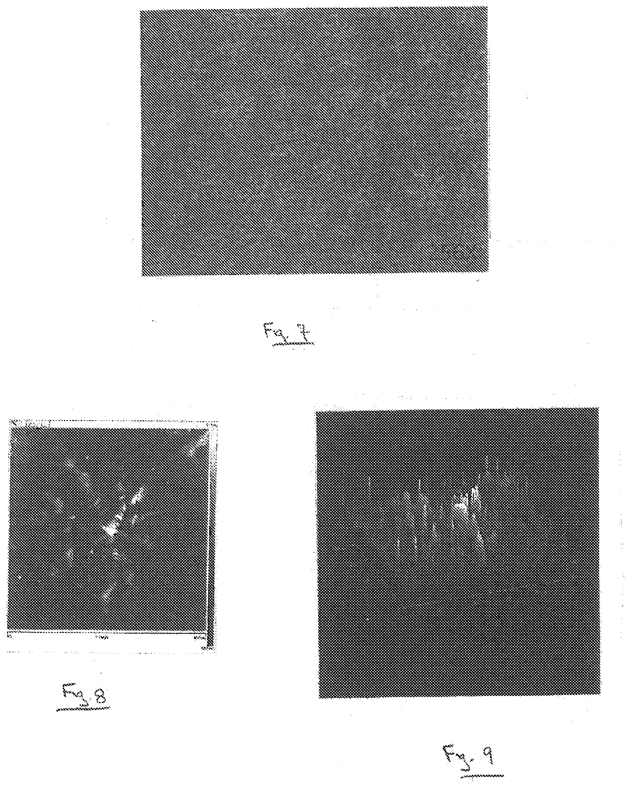

Fig. 7 is a micrograph of Sample 7c after heating. Fig. 8 is a two-dimensional atomic force micrograph (50 microns by 50 microns) of Sample 7c of Fig. 7. Fig. 9 is a three-dimensional atomic force micrograph (50 microns by 50 microns) for Sample 7c of Fig. 8. The defects were shaped as dendrites having branches. The dendrites had projections extending upwardly therefrom. At least some of the projections had a height of 40 nm. Sample 7c had a Pre-Heat root mean square (RMS) surface roughness of 0.64 nm. Post-Heating, the Sample 7c had a RMS roughness of 3.64 between the defects and a RMS surface roughness of 6.92 nm including the defects.

### Example 3 (not according to the present invention)

This Example illustrates an anode structure having an underlayer of zinc stannate (Zn₂SnO₄)/a metallic silver layer/a titanium primer layer/a top layer (protective layer) of zinc stannate (Zn₂SnO₄).

Table 5 lists the coater power settings during deposition of the listed targets. Substrates were coated with Ag and Ti for 1 pass and with zinc stannate for 4 passes (for both the underlayer and the top layer).

**TABLE 5**

| Coating # | SnZn | Ag | Ti | SnZn | T | Haze |
|---|---|---|---|---|---|---|
| 12 | 10 | 2 | 1.44 | 10 | 88.6 | 0.08 |
| 13 | 10 | 2.5 | 1.44 | 10 | 88.8 | 0.08 |
| 14 | 10 | 1 | 1.44 | 10 | 85.9 | 0.12 |
| 15 | 10 | 0.5 | 1.44 | 10 | 74.7 | 0.19 |
| 16 | 10 | 0.25 | 1.44 | 10 | 77.6 | 0.2 |
| 17 | 10 | 2 | 0 | 10 | 70.9 | 0.22 |

The coated substrates were measured for sheet resistance (Pre-Heat) and then heated in a box oven at 1300°F (704°C) for the times listed in Table 6. After heating, the coated substrates were allowed to cool to room temperature and then sheet resistance, transmittance, and haze were again measured (Post-Heat). The resultant values are shown in Table 6.

**TABLE 6**

| | | Sheet Resistance | | Post-Heat | |
|---|---|---|---|---|---|
| Sample | Time | Pre-Heat | Post-Heat | T | Haze |
| 12a | 3 | 5.6 | 4.4 | 90.3 | 0.08 |
| 12b | 3.5 | 6.1 | 4.9 | 90.3 | 0.07 |
| 12c | 4 | 5.8 | 4.9 | 89.9 | 0.08 |
| 12d | 5 | - | 4.9 | 89 | 0.15 |
| 12e | 5.5 | - | 5.5 | 88.4 | 0.32 |
| 13 | 3 | 9.1 | 8.2 | 89.6 | 0.09 |
| 14 | 3.5 | 8.9 | 7.5 | 90 | 0.12 |
| 13c | 4 | 8.4 | 7.9 | 89.3 | 0.09 |
| 13d | 5 | - | 9.65 | 87 | 0.09 |
| 13e | 5.5 | - | 9.5 | 86.3 | 0.21 |
| 15 | 3 | 16.5 | 18 | 85.7 | 0.13 |
| 16 | 3.5 | 15.8 | 17 | 85.8 | 0.17 |
| 14c | 4 | 17.5 | 20.9 | 84 | 0.32 |
| 17 | 3 | O/R | O/R | 79.7 | 0.16 |
| 18 | 3.5 | O/R | O/R | 78.9 | 0.05 |
| 19 | 4 | O/R | O/R | 78.6 | 0.06 |
| 16a | 3 | O/R | O/R | 79.5 | 0.13 |
| 16b | 3.5 | O/R | O/R | 79.2 | 0.07 |
| 16c | 4 | O/R | O/R | 79 | 0.04 |
| 17a | 3 | O/R | O/R | 81.3 | 0.14 |
| 17b | 3.5 | O/R | O/R | 80.2 | 0.06 |
| 17c | 4 | O/R | O/R | 79.6 | 0.04 |

### Example 4 (not according to the present invention)

This Example illustrates the use of a belt conveyor furnace rather than a box furnace for sample heating. Replicates of selected coating samples were heated in a conventional Lindberg furnace having five heating zones. Zone 1 had a temperature of 1130°F (610°C); zone 2 had a temperature of 1155°F (624°C); zone 3 had a temperature of 1155°F (624°C); zone 4 had a temperature of 1155°F (624°C); and zone 5 had a temperature of 1000°F (538°C). The Pre-Heat values for glass substrates with the listed coatings are shown in Table 7.

**TABLE 7**

| Coating | T | Haze | Sheet Resistance |
|---|---|---|---|
| 2 | 72.1 | 0.16 | 23.5 |
| 7 | 82.3 | 0.09 | 4.25 |
| 8 | 86 | 0.08 | 6.09 |
| 13 | 88.7 | 0.05 | 9.5 |

The samples of the coated glass substrates were then heated in the Lindberg furnace at the conveyor line speeds shown in Table 8. The line speeds are in inches per minute (centimeters per minute). The Post-Heat values for the samples are also shown in Table 8.

**TABLE 8**

| Sample | Line Speed | T | Haze | Sheet Resistance |
|---|---|---|---|---|
| 2f | 11 (28) | 76.8 | 5.85 | 12.3 |
| 2g | 8 (20) | 75.5 | 7.52 | 16.20 |
| 2h | 6 (15) | 75.9 | 7.62 | 24-30 |
| 2i | 6 (15) | 77.4 | 7.34 | 26.5 |
| 2j | 4 (10) | 74.8 | 7.89 | 19.5 |
| 2k | 2 (5) | 74.9 | 8.79 | 35.45 |
| 7e | 8 (20) | 81.1 | 2.23 | 12.2 |
| 8d | 8 (20) | 82.2 | 2.09 | 23.25 |
| 13f | 8 (20) | 88 | 0.14 | 10.5 |

## Claims

1. A light extracting electrode (26), comprising:
a metallic layer (28), wherein the metallic layer (28) comprises light scattering features (29) on and/or in the metallic layer (28), and
an underlayer (30) comprising a zinc oxide layer over a zinc stannate layer,
wherein the light extracting electrode (26) has a visible light transmittance at a wavelength of 550 nm of at least 50%.

2. The light extracting electrode (26)of claim 1, wherein the light scattering features (29):
- are selected from the group consisting of projections, dendrites, cracks, voids, regions of different density than the metallic layer (28), and regions of different chemical composition than the metallic layer (28),
- comprise projections, wherein preferably at least some of the projections have a minimum height of 5 nm, such as 10 nm, such as 15 nm, such as 20 nm, such as 25 nm, such as 30 nm, such as 35 nm, such as 40 nm, such as 50 nm, and/or have a maximum height of 100 nm, such as 90 nm, such as 80 nm, such as 70 nm, such as 60 nm, such as 55 nm, such as 50 nm, such as 45 nm, such as 40 nm, the light scattering features (29) preferably comprising projections having a height in the range of 5 nm to 100 nm, such as 10 nm to 80 nm, such as 20 nm to 60 nm, such as 30 nm to 60 nm, such as 30 nm to 50 nm, and/or
- are at least for some of the light scattering features (29) dendrite-shaped, wherein at least some of the dendrite-shaped light scattering features (29) preferably have a diameter in the range of 10 microns to 50 microns, such as 10 microns to 40 microns, such as 20 microns to 40 microns, such as 30 microns to 40 microns.

3. The light extracting electrode (26) of any of claims 1 to 2, wherein the metallic layer (28) comprises at least one metal selected from the group consisting of platinum, iridium, osmium, palladium, aluminum, gold, copper, silver, and mixtures and/or alloys thereof, the metallic layer (28) preferably comprising metallic silver.

4. The light extracting electrode (26) of any of claims 1 to 3, wherein the light extracting electrode (26):
- has a sheet resistance in the range of 1 Ω/□ to 20 Ω/□, such as 1 Ω/□ to 15 Ω/□, such as 1 Ω/□ to 10 Ω/□, such as 1 Ω/□ to 8 Ω/□, such as 2 Ω/□ to 8 Ω/□, such as 4 Ω/□ to 8 Ω/□,
- has a visible light transmittance in the range of 50 % to 97 %, such as 70 % to 95 %, such as 75 % to 95 %, such as 80 % to 95 %, such as 85 % to 95 %, such as 88 % to 95 %, such as 90 % to 95 %,
- has haze in the range of 0.5 % to 10 %, such as 1 % to 10 %, such as 1 % to 8 %, and/or
- has a root mean square surface roughness in the range of 5 nm to 60 nm, such as 25 nm to 60 nm, such as 40 nm to 60 nm, such as 50 nm to 60 nm.

5. The light extracting electrode (26) of any of claims 1 to 4, including a primer layer (36) over the metallic layer (28), wherein the primer layer (36) preferably comprises a material selected from the group consisting of titanium, silicon, silicon dioxide, silicon nitride, silicon oxynitride, nickel-chrome alloys, zirconium, aluminum, alloys of silicon and aluminum, alloys containing cobalt and chromium, and mixtures thereof, the primer layer (36) even more preferred comprising titanium.

6. The light extracting electrode (26) of any of claims 1 to 5, including a top layer (38) over the metallic layer (28), wherein the top layer (38) preferably comprises at least one oxide material selected from the group consisting of oxides of zinc, tin, zirconium, aluminum, silicon, indium, and mixtures thereof, such as zinc stannate, or a mixture of silica and alumina, or comprises a conductive layer selected from the group consisting of indium tin oxide, aluminum zinc oxide, and indium zinc oxide.

7. An organic light emitting diode (10), comprising:
- a substrate (20);
- a first electrode (12);
- an emissive active stack (14); and
- a second electrode (18),
wherein at least one of the first electrode (12) and the second electrode (18) is a light extracting electrode (26) as specified in any one of claims 1 to 6, wherein the underlayer (30) comprising a zinc oxide layer (34) over a zinc stannate layer (32) is located between the metallic layer (28) and the substrate (20).

8. The organic light emitting diode (10) of claim 7, wherein the first electrode (12) is a cathode selected from the group consisting of barium, calcium, and magnesium, and/or wherein the first electrode (12) is opaque and/or reflective.

9. The organic light emitting diode (10) of any of claims 7 or 8, wherein the substrate (20) comprises glass.

10. The organic light emitting diode (10) of any of claims 7 to 9, wherein the second electrode (18) is transparent, and/or closer to the substrate (20) than the first electrode (12).

11. The organic light emitting diode (10) of any of claims 7 to 10, wherein the substrate (20) comprises glass, wherein the first electrode (12) is a cathode, wherein the light extracting electrode (26) is an anode, wherein the light scattering features (29) comprise projections extending from a first surface (22) of the substrate (20), and wherein at least some of the projections have a height in the range of 20 nm to 60 nm, the organic light emitting diode optionally further including:
- a primer layer (36) over the metallic layer (28), wherein the primer layer (36) comprises titanium; and/or
- a top layer (38) over the metallic layer (28), wherein the top layer (38) is selected from the group consisting of zinc stannate, a mixture of silica and alumina, indium tin oxide, aluminum zinc oxide, and indium zinc oxide,
wherein preferably the cathode is opaque and/or reflective and the anode is closer to the substrate (20) than the cathode, and the metallic layer (28) comprises metallic silver.

12. A method of making an organic light emitting diode (10) as defined in any of claims 7 to 11, comprising:
providing a first electrode (12), an emissive active stack (14), and a second electrode (18) over a substrate (20), and
wherein at least one of the first and second electrodes (12, 18) is a light extracting electrode (26) comprising a metallic layer (28), and wherein the metallic layer (28) comprises light scattering features (29) on and/or in the metallic layer (28),
the method further including providing an underlayer (30) between the metallic layer (28) and the substrate (20), wherein the underlayer (30) comprises a zinc oxide layer (34) over a zinc stannate layer (32).

13. The method of claim 12, wherein the light scattering features (29) are provided by at least one process selected from:
exposing the metallic layer (28) to oxygen such as for a period of time in the range of 1 minute to 20 minutes, such as 1 minute to ten minutes, such as 1 minute to 5 minutes, such as 3 minutes to 5 minutes, such as 3 minutes to 4.5 minutes;
heating the metallic layer (28) such as to a temperature in the range of 400 °C to 1000 °C, such as 500 °C to 900 °C, such as 600 °C to 800 °C, such as 700 °C to 800 °C, such as 700 °C to 750 °C;
exposing the metallic layer (28) to a laser;
exposing the metallic layer (28) to an oxygen plasma treatment; and
doping the metallic layer (28).

14. The method of any of claims 12 or 13, including doping the metallic layer (28) with a dopant selected from the group consisting of copper, aluminum, and zinc.

15. The use of an organic light emitting diode (10) of any of claims 7 to 11 in a display device, particularly a display device selected from the group consisting of a computer monitor, a computer screen, a mobile phone, a television screen, a personal digital assistant, a watch, and a lighting device.

16. The use of a light extracting electrode (26) of any of claims 1 to 6 in an organic light emitting diode device or in a display device, particularly in a display device selected from the group consisting of a computer monitor, a computer screen, a mobile phone, a television screen, a personal digital assistant, a watch, and a lighting device.

## Patentansprüche

1. Eine Lichtextraktionselektrode (26) umfassend:
eine metallische Schicht (28), wobei die metallische Schicht (28) lichtstreuende Elemente (29) auf und/oder in der metallischen Schicht (28) umfasst, und
eine Unterschicht (30) umfassend eine Zinkoxidschicht über einer Zinkstannatschicht,
wobei die Lichtextraktionselektrode (26) eine Durchlässigkeit für sichtbares Licht bei einer Wellenlänge von 550 Nanometern (nm) von wenigstens 50% aufweist.

2. Die Lichtextraktionselektrode (26) des Anspruchs 1, wobei die lichtstreuenden Elemente (29):
- aus der Gruppe bestehend aus Vorsprüngen, Dendriten, Rissen, Hohlräumen, Bereichen von zu der metallischen Schicht (28) verschiedener Dichte und Bereichen von zu der metallischen Schicht (28) verschiedener chemischer Zusammensetzung ausgewählt sind,
- Vorsprünge umfassen, wobei vorzugsweise wenigstens einige der Vorsprünge eine Mindesthöhe von 5 nm, wie etwa 10 nm, wie etwa 15 nm, wie etwa 20 nm, wie etwa 25 nm, wie etwa 30 nm, wie etwa 35 nm, wie etwa 40 nm, wie etwa 50 nm aufweisen und/oder eine Maximalhöhe von 100 nm, wie etwa 90 nm, wie etwa 80 nm, wie etwa 70 nm, wie etwa 60 nm, wie etwa 55 nm, wie etwa 50 nm, wie etwa 45 nm, wie etwa 40 nm aufweisen, wobei die lichtstreuenden Elemente (29) vorzugsweise Vorsprünge, die eine Höhe im Bereich von 5 nm bis 100 nm, wie etwa 10 nm bis 80 nm, wie etwa 20 nm bis 60 nm, wie etwa 30 nm bis 60 nm, wie etwa 30 nm bis 50 nm aufweisen, umfassen, und/oder
- wenigstens für einige der lichtstreuenden Elemente (29) dendritenförmig sind, wobei wenigstens einige der dendritenförmigen lichtstreuenden Elemente (29) vorzugsweise einen Durchmesser im Bereich von 10 Mikrometern bis 50 Mikrometern, wie etwa 10 Mikrometer bis 40 Mikrometer, wie etwa 20 Mikrometer bis 40 Mikrometer, wie etwa 30 Mikrometer bis 40 Mikrometer aufweisen.

3. Die Lichtextraktionselektrode (26) gemäß irgendeinem der Ansprüche 1 oder 2, wobei die metallische Schicht (28) wenigstens ein Metall, ausgewählt aus der Gruppe bestehend aus Platin, Iridium, Osmium, Palladium, Aluminium, Gold, Kupfer, Silber und Mischungen und/oder Legierungen davon umfasst, wobei die metallische Schicht (28) vorzugsweise metallisches Silber umfasst.

4. Die Lichtextraktionselektrode (26) gemäß irgendeinem der Ansprüche 1 bis 3, wobei die Lichtextraktionselektrode (26):
- einen Flächenwiderstand im Bereich von 1 Ω/□ bis 20 Ω/□, wie etwa 1 Ω/□ bis 15 Ω/□, wie etwa 1 Ω/□ bis 10 Ω/□, wie etwa 1 Ω/□ bis 8 Ω/□, wie etwa 2 Ω/□ bis 8 Ω/□, wie etwa 4 Ω/□bis 8 Ω/□ aufweist,
- eine Durchlässigkeit für sichtbares Licht im Bereich von 50% bis 97%, wie etwa 70% bis 95%, wie etwa 75% bis 95%, wie etwa 80% bis 95%, wie etwa 85% bis 95%, wie etwa 88% bis 95%, wie etwa 90% bis 95% aufweist,
- einen Trübungswert im Bereich von 0,5% bis 10%, wie etwa 1% bis 10%, wie etwa 1% bis 8% aufweist, und/oder
- eine quadratisch gemittelte Oberflächenrauigkeit im Bereich von 5 nm bis 60 nm, wie etwa 25 nm bis 60 nm, wie etwa 40 nm bis 60 nm, wie etwa 50 nm bis 60 nm aufweist.

5. Die Lichtextraktionselektrode (26) gemäß irgendeinem der Ansprüche 1 bis 4, beinhaltend eine Primerschicht (36) über der metallischen Schicht (28), wobei die Primerschicht (36) vorzugsweise ein Material, ausgewählt aus der Gruppe bestehend aus Titan, Silizium, Siliziumdioxid, Siliziumnitrid, Siliziumoxynitrid, Nickel-Chrom-Legierungen, Zirkonium, Aluminium, Legierungen von Silizium und Aluminium, Legierungen enthaltend Cobalt und Chrom, und Mischungen derselben umfasst, wobei die Primerschicht (36) noch mehr bevorzugt Titan umfasst.

6. Die Lichtextraktionselektrode (26) gemäß irgendeinem der Ansprüche 1 bis 5, beinhaltend eine Deckschicht (38) über der metallischen Schicht (28), wobei die Deckschicht (38) vorzugsweise wenigstens ein Oxidmaterial, ausgewählt aus der Gruppe bestehend aus Oxiden von Zink, Zinn, Zirkonium, Aluminium, Silizium, Indium und Mischungen derselben, wie etwa Zinkstannat, oder eine Mischung von Siliziumdioxid und Aluminiumoxid, umfasst oder eine leitfähige Schicht, ausgewählt aus der Gruppe bestehend aus Indiumzinnoxid, Aluminiumzinkoxid und Indiumzinkoxid, umfasst.

7. Eine organische Leuchtdiode (10) umfassend:
- ein Substrat (20),
- eine erste Elektrode (12),
- einen emittierenden aktiven Stapel (14) und
- eine zweite Elektrode (18),
wobei wenigstens eine von der ersten Elektrode (12) und der zweiten Elektrode (18) eine Lichtextraktionselektrode (26), wie in irgendeinem der Ansprüche 1 bis 6 spezifiziert, ist, wobei die Unterschicht (30) umfassend eine Zinkoxidschicht (34) über einer Zinkstannatschicht (32) zwischen der metallischen Schicht (28) und dem Substrat (20) angeordnet ist.

8. Die organische Leuchtdiode (10) des Anspruchs 7, wobei die erste Elektrode (12) eine Kathode, ausgewählt aus der Gruppe bestehend aus Barium, Calcium und Magnesium ist und/oder wobei die erste Elektrode (12) opak und/oder reflektierend ist.

9. Die organische Leuchtdiode (10) gemäß irgendeinem der Ansprüche 7 oder 8, wobei das Substrat (20) Glas umfasst.

10. Die organische Leuchtdiode (10) gemäß irgendeinem der Ansprüche 7 bis 9, wobei die zweite Elektrode (18) transparent ist und/oder näher an dem Substrat (20) als die erste Elektrode (12) ist.

11. Die organische Leuchtdiode (10) gemäß irgendeinem der Ansprüche 7 bis 10, wobei das Substrat (20) Glas umfasst, wobei die erste Elektrode (12) eine Kathode ist, wobei die Lichtextraktionselektrode (26) eine Anode ist, wobei die lichtstreuenden Elemente (29) Vorsprünge, die sich von einer ersten Oberfläche (22) des Substrats (20) erstrecken, umfassen, und wobei wenigstens einige der Vorsprünge eine Höhe im Bereich von 20 nm bis 60 nm aufweisen, wobei die organische Leuchtdiode wahlweise des Weiteren enthält:
- eine Primerschicht (36) über der metallischen Schicht (28), wobei die Primerschicht (36) Titan umfasst, und/oder
- eine Deckschicht (38) über der metallischen Schicht (28), wobei die Deckschicht (38) aus der Gruppe bestehend aus Zinkstannat, einer Mischung von Siliziumoxid und Aluminiumoxid, Indiumzinnoxid, Aluminiumzinkoxid und Indiumzinkoxid ausgewählt ist,
wobei vorzugsweise die Kathode opak und/oder reflektierend ist und die Anode näher an dem Substrat (20) ist als die Kathode, und die metallische Schicht (28) metallisches Silber umfasst.

12. Ein Verfahren zum Herstellen einer organischen Leuchtdiode (10), wie in irgendeinem der Ansprüche 7 bis 11 definiert, umfassend:
Bereitstellen einer ersten Elektrode (12), eines emittierenden aktiven Stapels (14) und einer zweiten Elektrode (18) über einem Substrat (20), und
wobei wenigstens eine der ersten und zweiten Elektroden (12, 18) eine Lichtextraktionselektrode (26) umfassend eine metallische Schicht (28) ist, und wobei die metallische Schicht (28) lichtstreuende Elemente (29) auf und/oder in der metallischen Schicht (28) umfasst,
wobei das Verfahren des Weiteren ein Bereitstellen einer Unterschicht (30) zwischen der metallischen Schicht (28) und dem Substrat (20) beinhaltet, wobei die Unterschicht (30) eine Zinkoxidschicht (34) über einer Zinkstannatschicht (32) umfasst.

13. Das Verfahren gemäß Anspruch 12, wobei die lichtstreuenden Elemente (29) bereitgestellt werden durch wenigstens ein Verfahren ausgewählt aus:
Aussetzen der metallischen Schicht (28) gegenüber Sauerstoff, wie etwa für eine Zeitdauer im Bereich von 1 Minute bis 20 Minuten, wie etwa 1 Minute bis 10 Minuten, wie etwa 1 Minute bis 5 Minuten, wie etwa 3 Minuten bis 5 Minuten, wie etwa 3 Minuten bis 4,5 Minuten,
Erhitzen der metallischen Schicht (28), wie etwa auf eine Temperatur im Bereich von 400 °C bis 1.000 °C, wie etwa 500 °C bis 900 °C, wie etwa 600 °C bis 800 °C, wie etwa 700 °C bis 800 °C, wie etwa 700 °C bis 750 °C,
Aussetzen der metallischen Schicht (28) gegenüber einem Laser;
Aussetzen der metallischen Schicht (28) gegenüber einer Sauerstoff-Plasma-Behandlung, und
Dotieren der metallischen Schicht (28).

14. Das Verfahren gemäß irgendeinem der Ansprüche 12 oder 13 beinhaltend Dotieren der metallischen Schicht (28) mit einem Dotierungsmittel, ausgewählt aus der Gruppe bestehend aus Kupfer, Aluminium und Zink.

15. Die Verwendung einer organischen Leuchtdiode (10) gemäß irgendeinem der Ansprüche 7 bis 11 in einem Anzeigegerät, insbesondere einem Anzeigegerät ausgewählt aus der Gruppe bestehend aus einem Computerbildschirm, einem Computermonitor, einem Mobiltelefon, einem Fernsehbildschirm, einem persönlichen digitalen Assistenten, einer Uhr und einer Beleuchtungsvorrichtung.

16. Die Verwendung einer Lichtextraktionselektrode (26) gemäß irgendeinem der Ansprüche 1 bis 6 in einem organischen Leuchtdiodengerät oder in einem Anzeigegerät, vorzugsweise in einem Anzeigegerät, ausgewählt aus der Gruppe bestehend aus einem Computermonitor, einem Computerbildschirm, einem Mobiltelefon, einem Fernsehbildschirm, einem persönlichen digitalen Assistenten, einer Uhr und einer Beleuchtungsvorrichtung.

## Revendications

1. Electrode à photo-extraction (26), comprenant
- une couche métallique (28), laquelle couche métallique (28) comporte des éléments photo-diffractants (29), présents sur et/ou dans cette couche métallique (28),
- et une couche sous-jacente (30), qui comprend une couche d'oxyde de zinc par-dessus une couche de stannate de zinc,
laquelle électrode à photo-extraction (26) présente une transmittance en lumière visible d'au moins 50 % à la longueur d'onde de 550 nm.

2. Electrode à photo-extraction (26), conforme à la revendication 1, dans laquelle les éléments photo-diffractants (29)
- sont choisis dans l'ensemble formé par des saillies, dendrites, fissures, vides, zones de densité différente de celle de la couche métallique (28), et zones de composition chimique différente de celle de la couche métallique (28),
- comprennent des saillies, étant entendu qu'au moins certaines de ces saillies présentent une hauteur minimale de 5 nm, comme de 10 nm, de 15 nm, de 20 nm, de 25 nm, de 30 nm, de 35 nm, de 40 nm ou de 50 nm, et/ou présentent une hauteur maximale de 100 nm, comme de 90 nm, de 80 nm, de 70 nm, de 60 nm, de 55 nm, de 50 nm, de 45 nm ou de 40 nm, étant entendu que les éléments photo-diffractants comprennent de préférence des saillies dont la hauteur vaut de 5 à 100 nm, comme de 10 à 80 nm, de 20 à 60 nm, de 30 à 60 nm, ou de 30 à 50 nm,
- et/ou, pour au moins certains de ces éléments photo-diffractants (29), ont la forme d'une dendrite, étant entendu qu'au moins certains de ces éléments photo-diffractants (29) en forme de dendrite présentent de préférence un diamètre valant de 10 à 50 µm, comme de 10 à 40 µm, de 20 à 40 µm, ou de 30 à 40 µm.

3. Electrode à photo-extraction (26), conforme à l'une des revendications 1 et 2, dans laquelle la couche métallique (28) comprend au moins un métal choisi dans l'ensemble constitué par les platine, iridium, osmium, palladium, aluminium, or, cuivre et argent et leurs mélanges et/ou alliages, étant entendu que la couche métallique (28) comprend de préférence de l'argent à l'état de métal.

4. Electrode à photo-extraction (26), conforme à l'une des revendications 1 à 3, laquelle électrode à photo-extraction (26)
- présente une résistance surfacique valant de 1 à 20 Ω/□, comme de 1 à 15 Ω/□, de 1 à 10 Ω/□, de 1 à 8 Ω/□, de 2 à 8 Ω/□, ou de 4 à 8 Ω/□,
- présente une transmittance en lumière visible valant de 50 à 97 %, comme de 70 à 95 %, de 75 à 95 %, de 80 à 95 %, de 85 à 95 %, de 88 à 95 %, ou de 90 à 95 %,
- présente un degré de voile valant de 0,5 à 10 %, comme de 1 à 10 %, ou de 1 à 8 %,
- et/ou une rugosité de surface valant, en moyenne quadratique, de 5 à 60 nm, comme de 25 à 60 nm, de 40 à 60 nm, ou de 50 à 60 nm.

5. Electrode à photo-extraction (26), conforme à l'une des revendications 1 à 4, comportant une couche de primaire (36) disposée par-dessus la couche métallique (28), laquelle couche de primaire (36) comprend de préférence un matériau choisi dans l'ensemble formé par les suivants : titane, silicium, dioxyde de silicium, nitrure de silicium, oxynitrure de silicium, alliages nickel-chrome, zirconium, aluminium, alliages de silicium et d'aluminium, et alliages contenant du cobalt et du chrome, ainsi que les mélanges de ces matériaux, étant entendu qu'il est encore mieux que la couche de primaire (36) comprenne du titane.

6. Electrode à photo-extraction (26), conforme à l'une des revendications 1 à 5, comportant une couche de dessus (38) disposée par-dessus la couche métallique (28), laquelle couche de dessus (38) comprend au moins un matériau de type oxyde, choisi dans l'ensemble formé par les oxydes de zinc, d'étain, de zirconium, d'aluminium, de silicium et d'indium, ainsi que leurs mélanges, comme du stannate de zinc ou un mélange de silice et d'alumine, ou comprend une couche conductrice en un matériau choisi dans l'ensemble formé par l'oxyde d'indium-étain, l'oxyde d'aluminium-zinc et l'oxyde d'indium-zinc.

7. Diode électroluminescente organique (10), comprenant :
- un substrat (20),
- une première électrode (12),
- un empilement émissif actif (14),
- et une deuxième électrode (18),
dans laquelle au moins l'une des première (12) et deuxième (18) électrodes est une électrode à photo-extraction (26), conforme à l'une des revendications 1 à 6, dans laquelle la couche sous-jacente (30), qui comprend une couche d'oxyde de zinc (34) par-dessus une couche de stannate de zinc (32), est située entre la couche métallique (28) et le substrat (20).

8. Diode électroluminescente organique (10), conforme à la revendication 7, dans laquelle la première électrode (12) est une cathode en un matériau choisi dans l'ensemble formé par du baryum, du calcium et du magnésium, et/ou dans laquelle la première électrode (12) est opaque et/ou réfléchissante.

9. Diode électroluminescente organique (10), conforme à l'une des revendications 7 et 8, dans laquelle le substrat (20) comprend un verre.

10. Diode électroluminescente organique (10), conforme à l'une des revendications 7 à 9, dans laquelle la deuxième électrode (18) est transparente, et/ou plus proche du substrat (20) que la première électrode (12)

11. Diode électroluminescente organique (10), conforme à l'une des revendications 7 à 10, dans laquelle le substrat (20) comprend un verre, la première électrode (12) est une cathode, l'électrode à photo-extraction (26) est une anode, les éléments photo-diffractants (29) comprennent des saillies se projetant à partir d'une première surface (22) du substrat (20), et au moins certaines de ces saillies sont hautes de 20 à 60 nm, et laquelle diode électroluminescente organique comporte en outre, en option :
- une couche de primaire (36) par-dessus la couche métallique (28), laquelle couche de primaire (36) comprend du titane,
- et/ou une couche de dessus (38) par-dessus la couche métallique (28), laquelle couche de dessus (38) est en un matériau choisi dans l'ensemble formé par du stannate de zinc, un mélange de silice et d'alumine, de l'oxyde d'indium-étain, de l'oxyde d'aluminium-zinc et de l'oxyde d'indium-zinc,
étant entendu que, de préférence, la cathode est opaque et/ou réfléchissante, l'anode est plus proche du substrat (20) que la cathode, et la couche métallique (28) comprend de l'argent à l'état de métal.

12. Procédé de fabrication d'une diode électroluminescente organique (10) conforme à l'une des revendications 7 à 11, lequel procédé comporte l'étape suivante :
- disposer une première électrode (12), un empilement émissif actif (14) et une deuxième électrode (18) sur un substrat (20),
étant entendu qu'au moins l'une des première et deuxième électrodes (12, 18) est une électrode à photo-extraction (26) comprenant une couche métallique (28), laquelle couche métallique (28) comporte des éléments photo-diffractants (29), présents sur et/ou dans cette couche métallique (28),
et lequel procédé comporte en outre le fait de disposer une couche sous-jacente (30) entre la couche métallique (28) et le substrat (20), laquelle couche sous-jacente (30) comprend une couche d'oxyde de zinc (34) par-dessus une couche de stannate de zinc (32).

13. Procédé conforme à la revendication 12, dans lequel les éléments photo-diffractants (29) sont formés selon au moins un procédé choisi parmi les suivants :
- exposer la couche métallique (28) à de l'oxygène, comme durant un laps de temps de 1 à 20 minutes, comme de 1 à 10 minutes, de 1 à 5 minutes, de 3 à 5 minutes ou de 3 à 4,5 minutes,
- chauffer la couche métallique (28), comme à une température de 400 à 1000 °C, comme de 500 à 900 °C, de 600 à 800 °C, de 700 à 800 °C, ou de 700 à 750 °C,
- exposer la couche métallique (28) à un laser,
- exposer la couche métallique (28) à un traitement par plasma d'oxygène,
- et doper la couche métallique (28).

14. Procédé conforme à l'une des revendications 12 et 13, qui comporte le fait de doper la couche métallique (28) avec un dopant choisi dans l'ensemble formé par du cuivre, de l'aluminium et du zinc.

15. Utilisation d'une diode électroluminescente organique (10) conforme à l'une des revendications 7 à 11 dans un dispositif d'affichage, en particulier un dispositif d'affichage choisi dans l'ensemble formé par un moniteur d'ordinateur, un écran d'ordinateur, un téléphone mobile, un écran de téléviseur, un assistant numérique personnel et une montre, ou dans un dispositif d'éclairage.

16. Utilisation d'une électrode à photo-extraction (26) conforme à l'une des revendications 1 à 6 dans un dispositif à diodes électroluminescentes organiques ou dans un dispositif d'affichage, en particulier un dispositif d'affichage choisi dans l'ensemble formé par un moniteur d'ordinateur, un écran d'ordinateur, un téléphone mobile, un écran de téléviseur, un assistant numérique personnel et une montre, ou dans un dispositif d'éclairage.
